# FASCICULE DE BREVET EUROPEEN

(11) **EP 3 141 522 B1**
(45) Date de publication et mention de la délivrance du brevet: **02.05.2018**
(21) Numéro de dépôt: 15184188.9
(22) Date de dépôt: 08.09.2015
(51) Int. Cl.: B81C 1/00, G04B 31/08, G04B 15/14

(54) **PIÈCE MICROMÉCANIQUE HORLOGÈRE COMPRENANT UNE SURFACE LUBRIFIÉE ET PROCÉDÉ DE RÉALISATION D'UNE TELLE PIÈCE MICROMÉCANIQUE HORLOGÈRE**
MIKROMECHANISCHES UHRENBAUTEIL, DAS EINE GESCHMIERTE OBERFLÄCHE UMFASST, UND HERSTELLUNGSVERFAHREN EINES SOLCHEN MIKROMECHANISCHEN UHRENBAUTEILS
MICROMECHANICAL TIMEPIECE PART COMPRISING A LUBRICATED SURFACE AND METHOD FOR MANUFACTURING SUCH A MICROMECHANICAL TIMEPIECE PART

(43) Date de publication de la demande: 15.03.2017
(73) Titulaire: Nivarox-FAR S.A., 2400 Le Locle (CH)
(72) Inventeur: Dubois, Philippe, 2074 Marin (CH)
(74) Mandataire: Honoré, Anne-Claire

(56) Documents cités:
- EP-A1- 1 705 533
- DE-A1-102009 046 647
- H. FÖLL ET AL: "Formation and application of porous silicon", MATERIALS SCIENCE AND ENGINEERING R: REPORTS, vol. 39, no. 4, 1 novembre 2002 (2002-11-01), pages 93-141, XP055254970, CH ISSN: 0927-796X, DOI: 10.1016/S0927-796X(02)00090-6
- LANG W: "Silicon microstructuring technology", MATERIALS SCIENCE AND ENGINEERING R: REPORTS, ELSEVIER SEQUOIA S.A., LAUSANNE, CH, vol. 17, no. 1, 1 septembre 1996 (1996-09-01), pages 1-55, XP004013096, ISSN: 0927-796X, DOI: 10.1016/0927-796X(96)00190-8

## Description

### Domaine de l'invention

La présente invention se rapporte à une pièce micromécanique horlogère comprenant un substrat à base de silicium, lubrifié au moyen d'un agent tribologique. L'invention se rapporte également à un procédé de réalisation d'une telle pièce micromécanique horlogère.

### Arrière-plan de l'invention

Le silicium est un matériau de plus en plus utilisé dans la fabrication de pièces micromécaniques horlogères, notamment des pièces qui restent liées à un substrat à base de silicium sur lequel elles ont été usinées.

Par rapport aux métaux ou alliages classiquement utilisés pour fabriquer des pièces micromécaniques horlogères, telles que des roues dentées, ou les composants de l'échappement, le silicium présente de nombreux avantages. C'est un matériau très dur, d'un poids très léger qui lui permet donc de présenter une inertie très réduite et en conséquence d'améliorer le rendement. Le silicium permet également de réaliser des pièces complexes, ou monobloc.

Toutefois, tout comme les autres matériaux utilisés plus classiquement dans l'horlogerie, les pièces réalisées à partir d'un substrat à base de silicium doivent être lubrifiées. Par exemple, la demande de brevet DE 10 2009 046647 A1 décrit une pièce micromécanique horlogère en aluminium ayant une surface poreuse dont les pores comprennent un agent tribologique. Par ailleurs, il est connu d'utiliser par exemple un agent lubrifiant très fluide qui favorise un faible coefficient de frottement dans le cas de faibles pressions de contact. Toutefois, ce type de lubrifiant présente l'inconvénient de voir son effet s'estomper notamment lors de pressions de contact plus élevées du fait de la rupture du film lubrifiant. Il est connu que les techniques de supra-lubrification, basées sur la formation de brosses polymères (polymer brushes) déposées en surface et leur imprégnation avec un lubrifiant ayant une affinité avec les brosses polymères, permettent de réduire grandement le frottement pour une large gamme de sollicitations. Ces brosses polymères très souples se redressent lorsqu'elles sont imprégnées par le lubrifiant formant ainsi une sorte d'éponge gorgée de lubrifiant. Selon les régimes de frottement, lors de pressions de contact importantes, les filaments peuvent aisément se comprimer et restituer du lubrifiant dans le contact. Cela a pour conséquence la formation d'un film lubrifiant plus important qui aboutit à une baisse substantielle du coefficient de frottement et de l'usure. Toutefois, lors de sollicitations de longue durée, ces brosses polymères finissent par se dégrader (usure, arrachement de la surface), ce qui ne permet plus au revêtement de brosses polymères d'assurer sa fonction.

Il est donc nécessaire de proposer une nouvelle méthode pour lubrifier une pièce micromécanique horlogère à base de silicium permettant de contenir à la surface de la pièce à lubrifier des quantités suffisantes d'agent lubrifiant afin de réduire la fréquence des services d'entretien du mouvement horloger comprenant ladite pièce.

Il est également nécessaire de proposer une nouvelle méthode pour lubrifier une pièce micromécanique horlogère à base de silicium permettant de créer des conditions de lubrification permettant une réduction significative de l'usure et du coefficient de frottement, de manière à accroitre la fiabilité, le rendement et par conséquent la réserve de marche du mouvement horloger comportant cette pièce, et cela pour une large gamme de sollicitations.

### Résumé de l'invention

A cet effet, la présente invention concerne une pièce micromécanique horlogère comprenant un substrat à base de silicium ayant au moins une surface.

Selon l'invention, au moins une partie de ladite surface du substrat à base de silicium présente des pores débouchant à la surface externe de la pièce micromécanique horlogère, lesdits pores comprenant un agent tribologique.

La présente invention concerne également un procédé de réalisation d'une pièce micromécanique horlogère à partir d'un substrat à base de silicium, ledit substrat à base de silicium ayant une surface dont au moins une partie est lubrifiée par un agent tribologique, ledit procédé comprenant, dans l'ordre, les étapes de :
a) former des pores à la surface de la partie de ladite surface dudit substrat à base de silicium,
b) déposer dans lesdits pores ledit agent tribologique.

La formation de pores à partir de la surface du substrat à base de silicium permet de former une superstructure à base de silicium poreux présentant un certain degré de flexibilité capable d'accommoder différents régimes de pression en se déformant. De plus, ce type de structure présente des cavités qui permettent de contenir de manière durable une réserve importante de lubrifiant.

De plus, comme des brosses polymères sont déposées sur la superstructure à base de silicium poreux, le revêtement obtenu est capable de se gorger de lubrifiant et de le restituer lorsque ces brosses polymères sont comprimées. Ce revêtement favorise également la pénétration du lubrifiant dans les cavités de la superstructure à base de silicium poreux.

### Brève description des dessins

Les buts, avantages et caractéristiques de la présente invention apparaîtront plus clairement dans la description détaillée suivante de plusieurs formes de réalisation de l'invention données uniquement à titre d'exemples non limitatifs et illustrées par les dessins annexés sur lesquels :
- les figures 1 à 2 illustrent schématiquement les étapes d'une première variante d'un procédé de fabrication non couvert par l'invention.
- les figures 3 à 5 illustrent schématiquement les étapes d'une deuxième variante d'un procédé de fabrication non couvert par l'invention, et
- les figures 6 à 8 illustrent schématiquement les étapes du procédé de fabrication selon l'invention.

### Description détaillée de l'invention

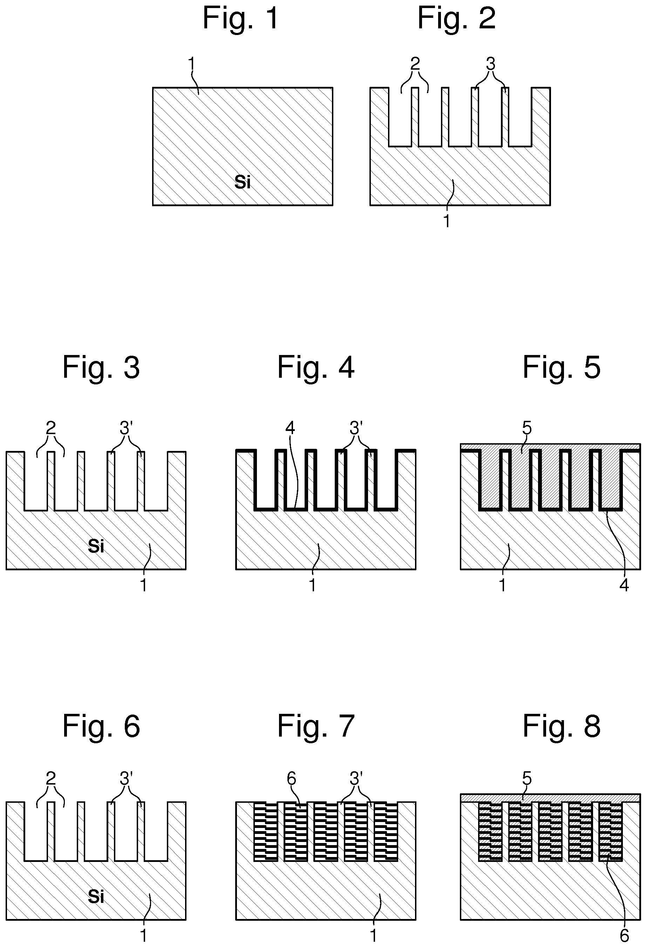

En référence aux figures 1 et 2, le procédé de réalisation d'une pièce micromécanique horlogère lubrifiée par un agent tribologique à partir d'un substrat à base de silicium 1 comprend tout d'abord une étape a) de formation de pores 2 à partir de la surface dudit substrat à base de silicium 1 sur une zone du substrat à base de silicium 1 correspondant à une zone à lubrifier. Les pores 2 sont agencés de manière à déboucher à la surface externe de la pièce micromécanique horlogère. Le substrat à base de silicium 1 est choisi en fonction de la pièce micromécanique horlogère à former. La forme finale du substrat à base de silicium 1 en fonction de la pièce micromécanique horlogère à fabriquer est donnée avant ou après la mise en oeuvre du procédé. Dans la présente fascicule, l'expression « substrat à base de silicium » désigne aussi bien une couche de silicium dans un substrat qu'un substrat en silicium. De préférence, le substrat à base de silicium 1 est un wafer de silicium ou un wafer SOI (Silicon-on-Insulator). Les pores peuvent être formés de préférence à la surface perpendiculaire au plan du substrat, c'est-à-dire sur les flancs de la pièce micromécanique qui sont en frottement, mais également à la surface parallèle au plan du substrat.
D'une manière avantageuse, cette étape a) peut être réalisée par un procédé choisi parmi le groupe comprenant un procédé par attaque électrochimique, un procédé de type « Stain-etch », et un procédé de type « MAC-Etch ».
Le procédé par attaque électrochimique peut être un procédé par anodisation électrochimique. Sa mise en oeuvre nécessite l'utilisation d'un bain électrochimique contenant de l'acide fluorhydrique en solution aqueuse ou mélangé à de l'éthanol dans des concentrations de 1 à 10%. Un courant électrique et des électrodes sont nécessaires pour créer des conditions électrochimiques induisant l'attaque du silicium. Selon les conditions électrochimiques, différents types de pores peuvent être obtenus. Un tel procédé est connu de l'homme du métier et ne nécessite pas d'informations détaillées ici.

Le procédé de type « Stain-etch » est basé sur une attaque humide du silicium aboutissant directement à la formation de silicium poreux. Typiquement, l'attaque se fait avec une solution HF/HNO₃/H₂O avec un rapport HF:HNO₃ de 50-500:1. Ce procédé présente l'avantage de ne pas nécessiter d'apport électrique dans le bain. Un tel procédé est connu de l'homme du métier et ne nécessite pas d'informations détaillées ici.

De préférence, l'étape a) est réalisée par un procédé de type « MAC-Etch ». Ce procédé est basé sur l'utilisation de particules de métaux nobles pour catalyser des réactions d'attaques chimiques locales. Typiquement, une couche très mince (10-50 nm) d'un métal noble (or, argent, platine) est déposée et structurée de manière aléatoire ou par lift-off, attaque, laser, etc. De préférence, le métal noble est de l'or. Plus particulièrement, on peut utiliser avantageusement des particules d'or en solution dans un mélange HF/H₂O₂. La taille des particules peut être comprise entre 5 et 1000 nm. La structuration peut être obtenue par lithographie de l'or, attaque ou lift-off. Une autre option est l'évaporation ou la pulvérisation cathodique (sputtering) d'une couche très fine non fermée (5-30 nm). Un traitement thermique pourra contribuer à la formation d'ilots d'or.

Lorsque le silicium avec la couche de métal noble est plongé dans une solution aqueuse d'un mélange HF/H₂O₂, le métal noble catalyse localement la dissolution du silicium. Cette solution d'attaque peut comprendre typiquement entre 4 ml : 1 ml : 8 ml (48% HF : 30% H₂O₂ : H₂O) et 4 ml : 1 ml : 40 ml (48% HF : 30% H₂O₂ : H₂O). La dissolution du silicium se produit préférentiellement sous le métal, celui-ci s'enfonçant alors progressivement dans le silicium. Cette réaction peut se poursuivre sur de grandes profondeurs (> 100 mµ) selon des modes de propagation essentiellement influencés par l'orientation du cristal de silicium, la disposition des surfaces, le dopage et la chimie du bain. Le procédé de type « MAC-Etch » présente l'avantage de ne pas nécessiter d'apport électrique dans le bain tout en autorisant la formation de pores de très grande profondeur (> 100 mµ) dans le silicium. Il est donc particulièrement adapté à l'utilisation, en tant que substrat, de wafers SOI généralement utilisés pour la fabrication des composants horlogers.
L'homme du métier connait les paramètres des procédés décrits ci-dessus à mettre en oeuvre pour que les pores formés dans le substrat à base de silicium présentent une géométrie et une taille appropriées.
Notamment, les pores peuvent présenter avantageusement un facteur d'aspect (rapport profondeur:diamètre) compris entre 5 et 100.
De préférence, les pores peuvent présenter une profondeur supérieure à 100 µm, de préférence supérieure à 200 µm et plus préférentiellement supérieure à 300 µm.
Comme représenté sur la figure 2, la formation de pores 2 dans le substrat à base de silicium 1 sur une certaine profondeur entraine la formation, entre les pores 2, de piliers 3 à base de silicium sur la même profondeur. De préférence, en considérant les piliers à base de silicium comme ayant une section circulaire, les pores 2 sont formés de sorte que la surface projetée des piliers 3 à base de silicium est inférieure à 79% de la surface totale apparente afin de ne pas avoir de piliers à base de silicium qui se touchent.
La deuxième étape b) du procédé consiste à déposer dans les pores 2, entre les piliers 3, un agent tribologique. L'agent tribologique est un lubrifiant, et peut être liquide, par exemple sous la forme d'une solution aqueuse, ou sec. D'une manière préférée, ledit agent tribologique est un polymère perfluorocarboné, tel que le polytétrafluoroéthylène (PTFE), ou tout autre agent tribologique ou lubrifiant approprié.
Selon une première variante du procédé de l'invention, l'agent tribologique est déposé selon l'étape b) directement dans les pores 2 du substrat à base de silicium. Cette étape b) peut être réalisée par un procédé de dépôt de couche mince, tel que CVD, iCVD, PECVD. Un traitement thermique approprié peut être appliqué pour polymériser l'agent tribologique, à des températures de l'ordre de 100°C à 300°C. Ainsi, des quantités importantes d'agent tribologique peuvent être emmagasinées à proximité de la surface du substrat à base de silicium, tout en conservant une dureté de surface apparente relativement élevée du fait du silicium.
D'une manière particulièrement avantageuse, les paramètres du procédé
de formation des pores 2 dans le substrat à base de silicium 1 selon l'étape
a) sont choisis pour que les pores 2 présentent une géométrie et une taille appropriées de sorte que les piliers 3, formés entre les pores 2, constituent des filaments 3' à base de silicium. Ces filaments 3' présentent un facteur d'aspect (rapport profondeur:diamètre) compris entre 5 et 100. Les filaments forment une superstructure flexible et sont ensuite imprégnés d'un agent tribologique choisi pour faciliter le mouillage des pores, conformément à l'étape b) du procédé selon l'invention.
Un substrat comprenant des filaments à base de silicium peut être utilisé selon deux autres variantes du procédé de l'invention.
Plus particulièrement en référence aux figures 3 à 5, selon une deuxième variante du procédé, il est prévu conformément à l'étape
a) de réaliser dans un substrat à base de silicium 1 des pores 2 de manière à former entre les pores 2 des piliers 3 sous la forme de filaments 3', comme le montre la figure 3. Il est alors prévu entre les étapes a) et b), une étape c) de dépôt d'au moins un agent de mouillage 4 de l'agent tribologique sur les parois des filaments 3' à base de silicium. L'agent de mouillage 4 est choisi pour faciliter le mouillage et la pénétration de l'agent
tribologique. Il est appliqué pour former une couche très mince (quelques nanomètres) afin de fonctionnaliser les parois des filaments 3' à base de silicium. Puis les filaments 3' sont imprégnés par un agent tribologique 5, selon l'étape b), l'agent tribologique 5 étant choisi pour faciliter le mouillage des pores 2. En référence aux figures 6 à 8, selon le procédé selon l'invention, il est prévu conformément à l'étape
a) de réaliser dans un substrat à base de silicium 1 des pores 2 de manière à former entre les pores 2 des piliers 3 sous la forme de filaments 3', comme le montre la figure 6. Il est alors prévu entre les étapes a) et b), une étape d) de dépôt d'au moins une brosse polymère 6 sur les parois des filaments 3' à base de silicium.
Une telle brosse polymère 6 est décrite par exemple dans les publications WO 2012/152512 et WO 2014/009059. Les brosses polymères présentent des filaments de longueur inférieure à celle des filaments à base de silicium de sorte que les filaments de polymère sont protégés par les filaments à base de silicium plus résistants mécaniquement. Puis les filaments 3' à base de silicium et les brosses polymères 6 sont imprégnés par un agent tribologique 5, selon l'étape b), l'agent tribologique 5 étant choisi pour faciliter le mouillage.
La présente invention concerne également une pièce micromécanique horlogère susceptible d'être obtenue par le procédé décrit ci-dessus. Ladite pièce micromécanique horlogère comprend un substrat à base de silicium 1 ayant au moins une surface, cette surface pouvant notamment être destinée à être en contact avec une surface d'une autre pièce micromécanique, lesdites pièces micromécaniques étant mobiles relativement l'une par rapport à l'autre.
Selon l'invention, au moins une partie de ladite surface présente des pores 2 débouchant à la surface externe de la pièce micromécanique horlogère, lesdits pores 2 comprenant un agent tribologique. Les pores 2 sont réalisés de manière à former, entre lesdits pores, des filaments 3' à base de silicium.
Selon un mode de réalisation non couvert par l'invention, les filaments 3' à base de silicium peuvent comporter des parois recouvertes d'au moins un agent de mouillage 4 de l'agent tribologique 5, les filaments à base de silicium étant imprégnés par l'agent tribologique 5.
Selon l'invention, les filaments 3' à base de silicium comportent des parois recouvertes d'au moins une brosse polymère 6, les filaments 3' à base de silicium et la brosse polymère 6 étant imprégnés par l'agent tribologique 5.
Le procédé selon l'invention permet de fabriquer des filaments directement dans la matière du substrat à base de silicium avec des géométries et des propriétés de flexion mécanique contrôlées permettant en cas d'utilisation de brosses polymères, de maintenir le comportement de supra-lubrification sur une large plage de régime de frottement tout en augmentant la fiabilité. Ainsi, le procédé selon l'invention permet de pallier au manque de résistance mécanique des brosses polymères habituellement utilisées en supra-lubrification. La structure formée de filaments à base de silicium constitue un réservoir de lubrifiant capable de restituer la quantité suffisante de lubrifiant dans le contact en fonction des sollicitations.
La géométrie des pores et des filaments à base de silicium peut être optimisée en fonction des régimes de frottement et objectifs tribologiques visés. La structuration du substrat à base de silicium peut aller de filaments à base de silicium à des pores ouverts et désordonnées formant une couche spongieuse.

## Revendications

1. Pièce micromécanique horlogère comprenant un substrat à base de silicium (1) ayant au moins une surface, au moins une partie de ladite surface présentant des pores (2) débouchant à la surface externe de la pièce micromécanique horlogère et comprenant un agent tribologique (5), des filaments (3') à base de silicium étant formés entre les pores (2), **caractérisée en ce que** les filaments (3') à base de silicium comportent des parois recouvertes d'au moins une brosse polymère (6), les filaments (3') à base de silicium et la brosse polymère (6) étant imprégnés par l'agent tribologique (5).

2. Pièce selon la revendication 1, **caractérisée en ce que** les pores (2) présentent un facteur d'aspect (rapport profondeur:diamètre) compris entre 5 et 100.

3. Pièce selon l'une des revendications précédentes, **caractérisée en ce que** les pores (2) présentent une profondeur supérieure à 100 µm, de préférence supérieure à 200 µm et plus préférentiellement supérieure à 300 µm.

4. Pièce selon l'une des revendications précédentes, **caractérisée en ce que** les filaments (3') à base de silicium présentent un facteur d'aspect (rapport profondeur:diamètre) compris entre 5 et 100.

5. Pièce selon l'une des revendications précédentes, **caractérisée en ce que** l'agent tribologique (5) est un polymère perfluorocarboné.

6. Pièce selon l'une des revendications précédentes, **caractérisée en ce que** le substrat à base de silicium (1) est issu d'un wafer de silicium ou d'un wafer SOI (Silicon-on-Insulator).

7. Procédé de réalisation d'une pièce micromécanique horlogère à partir d'un substrat à base de silicium (1), ledit substrat à base de silicium ayant une surface dont au moins une partie est lubrifiée par un agent tribologique (5), ledit procédé comprenant, dans l'ordre, les étapes de :
a) former des pores (2) à la surface de la partie de ladite surface dudit substrat à base de silicium (1), les pores (2) étant agencés de manière à former, entre les pores, des filaments (3') à base de silicium
b) déposer dans lesdits pores (2) ledit agent tribologique (5),
**caractérisé en ce que** ledit procédé comprend, entre les étapes a) et b), une étape d) de dépôt d'au moins une brosse polymère (6) sur les parois des filaments (3') à base de silicium.

8. Procédé selon la revendication 7, dans lequel l'étape a) est réalisée par un procédé choisi parmi le groupe comprenant un procédé par attaque électrochimique, un procédé de type « Stain-etch », et un procédé de type « MAC-Etch ».

9. Procédé selon la revendication 8, dans lequel l'étape a) est réalisée par un procédé de type « MAC-Etch ».

10. Procédé selon l'une des revendications 7 à 9, dans lequel l'étape b) est réalisée par un procédé de dépôt de couche mince.

## Patentansprüche

1. Mikromechanisches Uhrenteil, umfassend ein Substrat (1) auf Siliciumbasis, das mindestens eine Oberfläche besitzt, wobei zumindest ein Teil der Oberfläche Poren (2) aufweist, die in die äußere Oberfläche des mikromechanischen Uhrenteils münden und einen tribologischen Wirkstoff (5) enthalten, wobei zwischen den Poren (2) Filamente (3') auf Siliciumbasis gebildet sind, **dadurch gekennzeichnet, dass** die Filamente (3') auf Siliciumbasis Wände besitzen, die mit mindestens einer Polymerbürste (6) bedeckt sind, wobei die Filamente (3') auf Siliciumbasis und die Polymerbürste (6) durch den tribologischen Wirkstoff (5) imprägniert sind.

2. Teil nach Anspruch 1, **dadurch gekennzeichnet, dass** die Poren (2) ein Schlankheitsverhältnis (Verhältnis Tiefe:Durchmesser) besitzen, das im Bereich von 5 bis 100 liegt.

3. Teil nach einem der vorhergehenden Ansprüche, **dadurch gekennzeichnet, dass** die Poren (2) eine Tiefe von mehr als 100 µm, vorzugsweise mehr als 200 µm und besonders bevorzugt mehr als 300 µm aufweisen.

4. Teil nach einem der vorhergehenden Ansprüche, **dadurch gekennzeichnet, dass** die Filamente (3') auf Siliciumbasis ein Schlankheitsverhältnis (Verhältnis Tiefe:Durchmesser) im Bereich von 5 bis 100 aufweisen.

5. Teil nach einem der vorhergehenden Ansprüche, **dadurch gekennzeichnet, dass** der tribologische Wirkstoff (5) ein Perfluorkohlenwasserstoff-Polymer ist.

6. Teil nach einem der vorhergehenden Ansprüche, **dadurch gekennzeichnet, dass** das Substrat (1) auf Siliciumbasis von einem Silicium-Wafer oder einem SOI (Silicon-on-Insulator)-Wafer stammt.

7. Verfahren zum Herstellen eines mikromechanischen Uhrenteils anhand eines Substrats (1) auf Siliciumbasis, wobei das Substrat auf Siliciumbasis eine Oberfläche besitzt, von der zumindest ein Teil durch einen tribologischen Wirkstoff (5) geschmiert ist, wobei das Verfahren in der angegebenen Reihenfolge die Schritte umfasst:
a) Bilden von Poren (2) in der Oberfläche jenes Teils der Oberfläche des Substrats (1) auf Siliciumbasis, wobei die Poren (2) in einer Weise angeordnet sind, dass zwischen den Poren Filamente (3') auf Siliciumbasis gebildet werden,
b) Ablagern des tribologischen Wirkstoffs (5) in den Poren (2),
**dadurch gekennzeichnet, dass** das Verfahren zwischen dem Schritt a) und dem Schritt b) einen Schritt d) des Ablagerns mindestens einer Polymerbürste (6) auf den Wänden der Filamente (3') auf Siliciumbasis umfasst.

8. Verfahren nach Anspruch 7, wobei der Schritt a) durch ein Verfahren ausgeführt wird, das aus der Gruppe gewählt ist, die ein Verfahren mit elektrochemischer Ätzung, ein Verfahren des Typs "Stain-Etch" und ein Verfahren des Typs "MAC-Etch" umfasst.

9. Verfahren nach Anspruch 8, wobei der Schritt a) durch ein Verfahren des Typs "MAC-Etch" ausgeführt wird.

10. Verfahren nach einem der Ansprüche 7 bis 9, wobei der Schritt b) durch ein Dünnschichtablagerungsverfahren ausgeführt wird.

## Claims

1. Micromechanical timepiece part comprising a silicon-based substrate (1), having at least one surface, at least one part of said surface has pores (2) which open out at the external surface of the micromechanical timepiece part and comprise a tribological agent (5), silicon-based fibres (3') being formed between the pores (2), **characterised in that** silicon-based fibres (3') comprise walls which are covered with at least one polymer brush (6), the silicon-based fibres (3') and the polymer brush (6) being impregnated with the tribological agent (5).

2. Micromechanical timepiece part according to claim 1, **characterised in that** the pores (2) have an aspect factor (depth : diameter ratio) between 5 and 100.

3. Micromechanical timepiece part according to one of the preceding claims, **characterised in that** the pores (2) have a depth greater than 100 µm, preferably greater than 200 µm and more preferably greater than 300 µm.

4. Micromechanical timepiece part according to one of the preceding claims, **characterised in that** the silicon-based fibres (3') have an aspect factor (depth : diameter ratio) between 5 and 100.

5. Micromechanical timepiece part according to one of the preceding claims, **characterised in that** the tribological agent (5) is a perfluorocarbonated polymer.

6. Micromechanical timepiece part according to one of the preceding claims, **characterised in that** the silicon-based substrate (1) is a silicon wafer or an SOI wafer (Silicon-on-Insulator).

7. Method for producing a micromechanical timepiece part starting from a silicon-based substrate (1), said silicon-based substrate having a surface, at least one part of which is lubricated by a tribological agent (5), said method comprising, in order, the steps of:
a) forming pores (2) on the surface of the part of said surface of said silicon-based substrate (1), the pores (2) being designed in order to form, between the pores, silicon-based fibres (3')
b) depositing said tribological agent (5) in said pores (2),
**characterized in that** said method comprises, between steps a) and b), a step d) of depositing at least one polymer brush (6) on the walls of the silicon-based fibres (3').

8. Method according to claim 7, wherein step a) is achieved by a method chosen from the group comprising a method by electrochemical etching, a method of the « Stain-etch » type, and a method of the << MAC-Etch >> type.

9. Method according to claim 8, wherein step a) is achieved by a method of the « MAC-Etch » type.

10. Method according to one of claims 7 to 9, wherein step b) is achieved by a method of thin-film deposition.
